(19) Europäisches Patentamt / European Patent Office / Office européen des brevets

(11) **EP 2 805 360 B1**

(12) **EUROPÄISCHE PATENTSCHRIFT**

(45) Veröffentlichungstag und Bekanntmachung des Hinweises auf die Patenterteilung:
**14.06.2017   Patentblatt 2017/24**

(21) Anmeldenummer: **13702941.9**

(22) Anmeldetag: **17.01.2013**

(51) Int Cl.:
*H01L 35/16* (2006.01)      *H01L 35/26* (2006.01)
*H01L 35/34* (2006.01)      *H01L 35/32* (2006.01)

(86) Internationale Anmeldenummer:
**PCT/EP2013/050802**

(87) Internationale Veröffentlichungsnummer:
**WO 2013/124095 (29.08.2013 Gazette 2013/35)**

(54) **THERMOELEKTRISCHES ELEMENT**

THERMOELECTRIC ELEMENT

ÉLÉMENT THERMOELECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.02.2012   DE 102012101492**
                **20.06.2012   DE 102012105373**

(43) Veröffentlichungstag der Anmeldung:
**26.11.2014   Patentblatt 2014/48**

(73) Patentinhaber: **O-Flexx Technologies GmbH**
**47059 Duisburg (DE)**

(72) Erfinder:
• **SPAN, Gerhard**
  **A-6112 Wattens (AT)**

• **SIEGLOCH, Arwed**
  **74523 Schwäbisch Hall (DE)**
• **HAFERKAMP, Juergen**
  **45478 Mülheim/Ruhr (DE)**
• **IOSAD, Nikolay**
  **65232 Taunusstein (DE)**

(74) Vertreter: **Kohlmann, Kai**
**Donatusstraße 1**
**52078 Aachen (DE)**

(56) Entgegenhaltungen:
**US-A1- 2006 076 046      US-A1- 2006 289 050**
**US-A1- 2011 000 517      US-B1- 6 281 120**

## Beschreibung

Die Erfindung betrifft ein thermoelektrisches Element.

Die Wirkungsweise thermoelektrischer Elemente beruht auf dem thermoelektrischen Effekt:

Durch den thermoelektrischen Effekt, auch als Seebeck-Effekt bezeichnet, entsteht zwischen zwei Punkten eines elektrischen Leiters bzw. Halbleiters die eine verschiedene Temperatur haben, eine elektrische Spannung. Der Seebeck-Effekt beschreibt die umkehrbare Wechselwirkung zwischen Temperatur und Elektrizität. Die Seebeck-Spannung wird bestimmt durch:

$$U_{Seebeck} = \alpha \times \delta T$$

mit

$\delta T$ Temperaturdifferenz zwischen heißer und kalter Seite $\alpha$ - Seebeck - Koeffizient bzw. Thermokraft

Der Seebeck-Koeffizient hat die Dimension einer elektrischen Spannung pro Temperaturdifferenz (V/K). Die Größe des Seebeck-Koeffizienten ist maßgeblich für die Höhe der Seebeck-Spannung verantwortlich.

Die thermoelektrischen Elemente bestehen vorzugsweise aus unterschiedlich dotierten Halbleitermaterialien, wodurch sich die Effizienz gegenüber Thermoelementen aus Metallen, wesentlich steigern lässt. Gebräuchliche Halbleitermaterialien sind $Bi_2Te_3$, $PbTe$, $Bi_2Se_3$, $SiGe$, $BiSb$ oder $FeSi_2$.

Während der Seebeck-Effekt das Entstehen einer Spannung beschreibt, tritt der Peltier-Effekt ausschließlich durch das Fließen eines äußern Stromes auf. Der Peltier-Effekt tritt auf, wenn zwei Leiter oder Halbleiter mit unterschiedlichen elektronischen Wärmekapazitäten in Kontakt gebracht werden und durch einen elektrischen Strom Elektroden aus dem einen Leiter / Halbleiter in den anderen fließen. Mit geeigneten Materialien, insbesondere Halbleiter-Materialien gelingt es, mit elektrischem Strom Temperaturdifferenzen oder umgekehrt aus Temperaturdifferenzen elektrischen Strom zu erzeugen.

Um ausreichend hohe Spannungen zu erhalten, werden mehrere thermoelektrische Elemente zu einem thermoelektrischen Modul zusammengefasst und elektrisch in Reihe und ggf. auch parallel geschaltet.

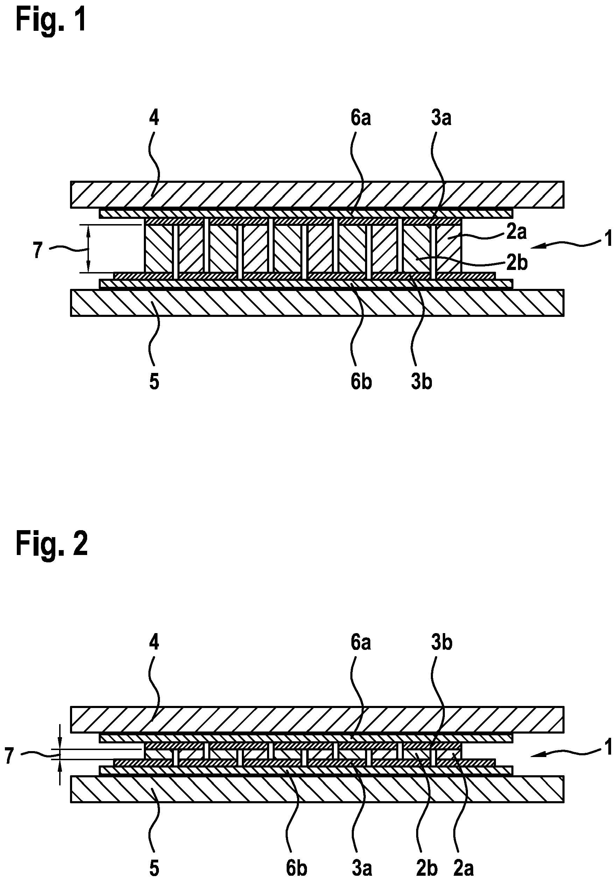

Ein in Abbildung 1 dargestelltes thermoelektrisches Peltier-Modul besteht aus mehreren in Reihe geschalteten thermoelektrischen Elementen. Die thermoelektrischen Elemente (1) bestehen jeweils aus kleinen Quadern (2a, 2b) aus p- und n-dotiertem Halbleitermaterial, die abwechselnd oben und unten mit Metallbrücken (3a, 3b) versehen sind. Die Metallbrücken (3a, 3b) bilden die thermischen und elektrischen Kontakte der thermoelektrischen Elemente (1) auf einer heißen bzw. einer kalten Seite (4, 5) des thermoelektrischen Moduls und sind zumeist zwischen zwei im Abstand zueinander angeordneten Keramikplatten (6a, 6b) angeordnet. Die unterschiedlich dotierten Quader (2a, 2b) sind durch die Metallbrücken (3a, 3b) derart miteinander verbunden, dass sie eine Reihenschaltung ergeben.

Sofern den Quadern (2a, 2b) ein elektrischer Strom zugeführt wird, kühlen sich abhängig von der Stromstärke und Stromrichtung die Verbindungsstellen der Quader (2a, 2b) auf der einen Seite (4, 5) ab, während sie sich auf der gegenüberliegenden Seite (4, 5) erwärmen. Der angelegte Strom erzeugt damit eine Temperaturdifferenz zwischen den Keramikplatten (6a, 6b). Wird indessen eine unterschiedlich hohe Temperatur an den gegenüberliegenden Keramikplatten (6a, 6b) angelegt, wird abhängig von der Temperaturdifferenz ein Stromfluss in den Quadern (2a, 2b) jedes thermoelektrischen Elementes (1) des Moduls hervorgerufen.

Die Kantenlänge (7) der Quader (2a, 2b) senkrecht zu den Keramikplatten (6a, 6b) beträgt etwa 3 - 5 mm. Die große Kantenlänge (7) bedingt einen hohen thermischen Widerstand zwischen der heißen und kalten Seite (4, 5), so dass die Seebeck-Spannung und die Leistung des Moduls gegenüber einem in Abbildung 2 dargestellten Peltier-Modul mit geringerer Kantenlänge (7) der Quader (2a, 2b), jedoch gleichem Querschnitt der Quader (2a, 2b) größer ist. Die Quader (2a, 2b) mit größerer Kantenlänge (7) benötigen jedoch mehr Halbleitermaterial.

Die Umwandlungseffizienz der üblichen, oben genannten thermoelektrischen Materialien liegt derzeit im Bereich unterhalb von 5%. Das bedeutet, dass der Wärmestrom mehr als das 20-fache der benötigten elektrischen Leistung betragen muss. Da die spezifische Wärmeleitfähigkeit der üblichen, oben genannten thermoelektrischen Materialien im Bereich von 1-5 W/mK liegt, muss die spezifische Wärmeleitfähigkeit der thermischen Kontakte der Quader deutlich über 20 - 100 W/mK liegen.

Der Wärmestrom in den Quadern nimmt bei gleichem Querschnitt der Quader (2a, b) mit zunehmender Kantenlänge (7) ab. Die erzielbaren thermischen Widerstände sind daher nur von der spezifischen Wärmeleitfähigkeit und der Kantenlänge (7) der Quader (2a, b) abhängig. Daher sind thermoelektrische Elemente, wie in Figur 2 dargestellt, noch schwieriger mit Wärme zu versorgen.

Die US2006/0076046 offenbart ein thermoelektrisches Bauelement.

Die US 2011 0000517 A1 offenbart ein im Wege von Herstellungsverfahren für Halbleiter herstellbares thermoelektrisches Element mit einem ersten und einen zweiten thermoelektrischen Schenkel, wobei der erste Schenkel auf einer ersten Elektrode und der zweite Schenkel auf einer zweiten Elektrode angeordnet sind. Eine gemeinsame Elektrode ist zudem auf dem ersten und zweiten Schenkel angeordnet. Die Schenkel bestehen jeweils aus zwei Halbleiterabschnitten, die jeweils durch einen Barriereabschnitt voneinander getrennt sind. Der Barriereabschnitt weist eine niedrigere thermische, jedoch höhere elektrische Leitfähigkeit, als die angrenzenden Halbleiterabschnitte auf. Der Barriereabschnitt soll die thermische Leitfähigkeit des Schenkels reduzieren und dessen elektrische Leitfähigkeit verbessern. Eine isolierende Lage, in der die Schenkel eingebettet sind, erstreckt sich über die volle Breite des thermoelektrischen Elementes.

Ausgehend von diesem Stand der Technik liegt der Erfindung die Aufgabe zu Grunde, ein thermoelektrisches Element mit hohem thermischem Widerstand vorzuschlagen, das gegenüber einem herkömmlichen thermoelektrischen Element mit vergleichbarer Leistung weniger Halbleitermaterial benötigt. Des Weiteren soll ein Verfahren zur Herstellung eines derartigen thermoelektrischen Elementes angegeben werden.

Im Einzelnen wird die Aufgabe durch ein thermoelektrisches Element umfassend ein Substrat mit einer Substratvorderseite und einer der Substratvorderseite gegenüberliegenden Substratrückseite, einen ersten Kontakt, der als Schicht auf der Substratvorderseite aufgebracht ist, einen zweiten Kontakt, der als Schicht auf der Substratvorderseite aufgebracht ist, eine Unterbrechung zwischen dem ersten und zweiten Kontakt, die den ersten und zweiten Kontakt thermisch und elektrisch voneinander trennt, wobei zumindest der Verlauf der Unterbrechung zwischen dem ersten und zweiten Kontakt nicht geradlinig ist und eine thermoelektrisch wirksame Schicht mit einer Oberseite und einer Unterseite, die durch seitliche Begrenzungsflächen miteinander verbunden sind, wobei die thermoelektrisch wirksame Schicht derart in der Unterbrechung angeordnet ist, dass die Unterseite auf der Substratvorderseite aufliegt und eine der seitlichen Begrenzungsflächen an dem ersten Kontakt sowie eine der seitlichen Begrenzungsflächen an dem zweiten Kontakt anliegen, gelöst.

Ein Vorteil des erfindungsgemäßen thermoelektrischen Elementes besteht darin, dass unter Berücksichtigung der technischen Grenzen der Abstand zwischen dem ersten und zweiten Kontakt und damit der thermische Widerstand frei wählbar ist, obwohl das thermoelektrisch wirksame Material als Schicht, insbesondere Dünnschicht ausgeführt ist. Trotz des hohen thermischen Widerstandes ist der Platzbedarf des thermoelektrischen Elementes außerordentlich gering, da sowohl die elektrischen und thermischen Kontakte als auch das thermoelektrisch wirksame Material als Schichten in einer Ebene auf der Substratoberfläche aufgebracht sind. Des Weiteren wird für die in der Unterbrechung angeordnete thermoelektrisch wirksame Schicht, trotz des mit herkömmlichen thermoelektrischen Elementen nach Abbildung 1 vergleichbaren thermischen Widerstandes, deutlich weniger thermoelektrisches Material benötigt.

Um die Länge der Unterbrechung zu vergrößern, ist diese nicht gradlinig, sondern insbesondere wellen- oder mäanderförmig ausgeführt. Bei unterstellter gleichbleibender Schichtdicke vergrößern sich gegenüber einem gradlinigen Verlauf die seitlichen Begrenzungsflächen der thermoelektrisch wirksamen Schicht, die an dem ersten und zweiten Kontakt anliegen. Hierdurch wird der elektrische Widerstand zwischen den Kontakten und der thermoelektrischen wirksamen Schicht reduziert. Der thermische Widerstand bleibt indes gegenüber einem geradlinigen Verlauf der Unterbrechung bei unterstellter übereinstimmender Breite der Unterbrechung hinreichend hoch. Hieraus resultiert eine nochmals verbesserte Leistung des thermoelektrischen Elementes.

Durch die Ein- bzw. Auskopplung der Wärme über die seitlichen Begrenzungsflächen der thermoelektrisch wirksamen Schicht, werden die Nachteile des Standes der Technik ausgeräumt, wonach die Ein- und Auskopplung über den unabhängig von ihrer Kantenlänge stets gleich bleibenden Querschnitt der Quader erfolgt. Bei der Erfindung kann die Größe der Anlagefläche zwischen den seitlichen Begrenzungsflächen und dem ersten bzw. zweiten Kontakt in weiten Grenzen variiert werden.

Die Unterbrechung ist insbesondere als Graben zwischen den Kontakten ausgeführt. Die den Graben beidseitig begrenzenden seitlichen Ränder der Kontakte sind gegenüber der Substratvorderseite vorzugsweise geneigt. Die in Richtung des Grabeninneren geneigten Ränder begünstigen das Abscheiden der thermoelektrisch wirksamen Schicht in der Unterbrechung.

Sofern die elektrische und/oder thermische Kontaktierung des thermoelektrischen Elementes auf der Substratrückseite erfolgen soll, ist in einer Ausgestaltung der Erfindung vorgesehen, dass

- ein dritter Kontakt als Schicht auf der Substratrückseite aufgebracht ist,

- ein vierter Kontakt als Schicht auf der Substratrückseite aufgebracht ist,

- eine Unterbrechung zwischen dem dritten und vierten Kontakt angeordnet ist, die den dritten und vierten Kontakt thermisch und elektrisch voneinander trennt,

- mindestens eine erste Durchkontaktierung den ersten und dritten Kontakt thermisch und elektrisch miteinander verbindet und

- mindestens eine zweite Durchkontaktierung den zweiten und vierten Kontakt thermisch und elektrisch miteinander verbindet.

Die Durchkontaktierung zwischen Vorder- und Rückseite des Substrats zwischen dem ersten und dritten sowie dem zweiten und vierten Kontakt kann beispielsweise als eine innen metallisierte Bohrung durch das Substrat ausgeführt werden.

Um den Materialverbrauch für das thermoelektrische Element weiter zu reduzieren, sind sämtliche Schichten auf der Substratvorderseite und auf der Substratrückseite vorzugsweise als Dünnschichten aufgebracht. Die Dicke der im Wege der Dünnschichttechnologie abgeschiedenen Schichten liegt typischerweise im Bereich von wenigen Mikrometern; sie beträgt höchstens jedoch 100 $\mu$m.

Wenn die thermoelektrisch wirksame Schicht mehrere Lagen aus einem Haftmaterial und mehrere Lagen aus einem thermoelektrischen Material aufweist und sich die Lagen aus Haftmaterial und thermoelektrischem Material zwischen der Ober- und Unterseite der thermoelektrisch wirksamen Schicht abwechseln, wird hierdurch bewirkt, dass die thermoelektrisch wirksame Schicht mechanisch stabiler als eine Schicht ausschließlich aus thermoelektrischem Material ist und zugleich einen geringeren thermischen AusdehnungsKoeffizienten aufweist. Hierdurch wird insbesondere ein Ablösen der seitlichen Begrenzungsflächen der thermoelektrisch wirksamen Schicht von dem ersten bzw. zweiten Kontakt verhindert.

Ein Vorfahren zur Herstellung eines erfindungsgemäßen thermoelektrischen Elementes umfasst die Schritte Aufbringen einer Metallisierungsschicht auf einer Substratvorderseite eines Substrats, Strukturieren einer Unterbrechung in der Metallisierungsschicht durch gezieltes Entfernen der Metallisierungsschicht von der Substratvorderseite, so dass die Unterbrechung die Metallisierung in einen ersten Kontakt und einen zweiten Kontakt unterteilt, Abscheiden einer thermoelektrisch wirksamen Schicht in die Unterbrechung, so dass die Unterbrechung zumindest teilweise mit der Schicht aus thermoelektrisch wirksamem Material aufgefüllt wird.

Als Substrat wird beispielsweise eine Platte oder Folie, insbesondere aus Polyimid verwendet. Die Platte kann insbesondere glasfaserverstärkt sein. Als Metallisierungsschicht wird insbesondere Kupfer oder ein anderes thermisch- und elektrisch gut leitendes Metall aufgebracht. Zur Herstellung der thermoelektrisch wirksamen Schicht wird in die zuvor strukturierte Unterbrechung zumindest thermoelektrisches Material, insbesondere Bismuth Tellurid oder ein anderes, der eingangs genannten gebräuchlichen Halbleitermaterialien abgeschieden.

Sofern die thermische und elektrische Kontaktierung auf der Substratrückseite erfolgen soll, umfasst das Herstellungsverfahren zusätzlich die Schritte Aufbringen einer Metallisierungsschicht auf einer der Substratvorderseite gegenüberliegenden Rückseite des Substrats, Strukturieren einer Unterbrechung in der Metallisierungsschicht auf der Rückseite durch gezieltes Entfernen der Metallisierungsschicht von der Substratrückseite, so dass die Unterbrechung die Metallisierung in einen dritten Kontakt und einen vierten Kontakt unterteilt, Herstellen mindestens einer ersten Durchkontaktierung, die den ersten und dritten Kontakt thermisch und elektrisch miteinander verbindet und Herstellen mindestens einer zweiten Durchkontaktierung, die den zweiten und vierten Kontakt thermisch und elektrisch miteinander verbindet.

Zur Metallisierung der Rückseite wird ebenfalls vorzugsweise Kupfer oder ein anderes thermisch- und elektrisch gut leitendes Metall verwendet. Zum Herstellen der Durchkontaktierung können Bohrungen in das Substrat eingebracht werden, die ihrerseits metallisiert werden, um die auf der Vorder- und Rückseite aufgebrachten Metallisierungsschichten elektrisch und thermisch leitend miteinander zu verbinden.

Das Abscheiden der Schichten als Dünnschichten erfolgt vorzugsweise mit Verfahren der physikalischen oder chemischen Gasphasenabscheidung. Als bevorzugtes Verfahren der physikalischen Gasphasenabscheidung kommt insbesondere das Sputtern in Betracht.

Die Strukturierung der Metallisierungsschichten erfolgt vorzugsweise im Rahmen des in der Halbleitertechnik üblichen Ätzens. Dabei kommen insbesondere Trockenätzverfahren, wie Plasmaätzen, reaktives Ionen-Tiefenätzen sowie nass-chemische Verfahren in Betracht.

Selbstverständlich liegt es im Rahmen der Erfindung, die Strukturierung im Wege anderer, insbesondere mechanischer Abtragsverfahren durchzuführen.

Um die bereits erwähnte, vorteilhafte mehrlagige thermoelektrisch wirksame Schicht in der Unterbrechung abzuscheiden, wird zunächst ein Haftmaterial auf der Substratoberfläche abgeschieden. Als Haftmaterial eignet sich insbesondere Titan (Ti). Sodann werden abwechselnd Lagen aus thermoelektrischem Material, wie beispielsweise Bismuth-Tellurid, und Haftmaterial, wie beispielsweise Titan, abgeschieden.

Nachfolgend wird die Erfindung anhand der Figuren näher erläutert. Es zeigen:

**Abbildung 3**    ein erstes Ausführungsbeispiel eines thermoelektrischen Elementes,

**Abbildung 4** ein zweites Ausführungsbeispiel eines thermoelektrischen Elementes,

**Abbildung 5** eine Ansicht nicht gemäß der Erfindung der Vorderseite des thermoelektrischen Elementes nach Abbildung 4,

**Abbildung 6** eine Ansicht der Rückseite des thermoelektrischen Elementes nach Abbildung 4,

**Abbildung 7** eine perspektivische Ansicht eines Ausführungsbeispieles eines erfindungsgemäßen thermoelektrischen Elementes sowie

**Abbildung 8** einen vergrößerten Schnitt durch eine Unterbrechung mit darin angeordneter thermoelektrisch wirksamer Schicht eines erfindungsgemäßen thermoelektrischen Elementes.

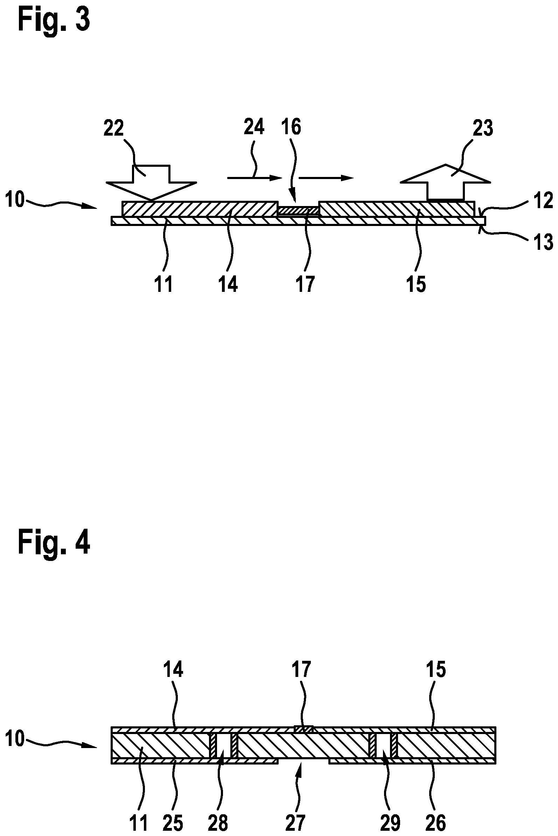

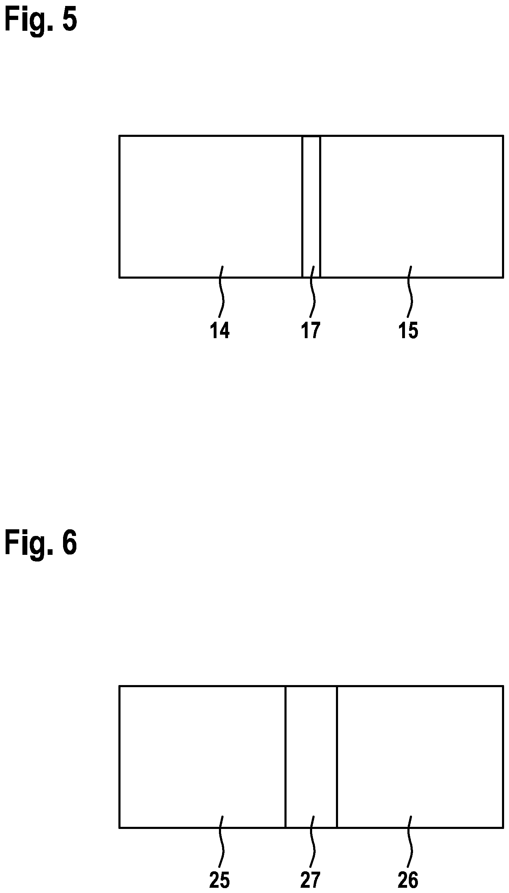

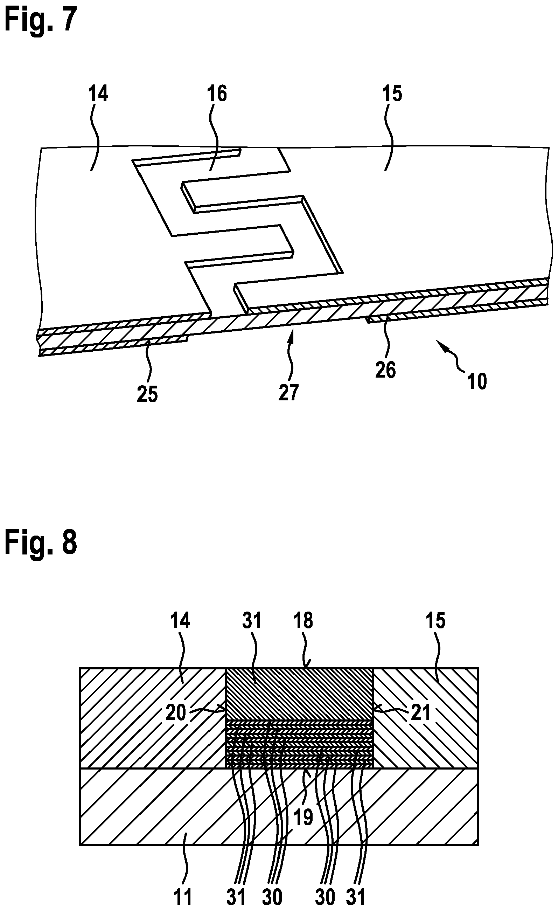

Abbildung 3 zeigt ein erstes Ausführungsbeispiel eines thermoelektrischen Elementes (10) mit einem ebenen Substrat (11) aus Polyimid mit einer Substratvorderseite (12) und einer der Substratvorderseite (12) gegenüberliegenden Substratrückseite (13). Auf der Substratvorderseite (12) sind ein erster Kontakt (14) und ein zweiter Kontakt (15) als Kupferschicht aufgebracht. Die Schichten sind zur Verdeutlichung der Erfindung nicht maßstäblich, sondern überhöht dargestellt. Die tatsächliche Dicke der Kupferschicht beträgt maximal 100 $\mu$m. In der Aufsicht sind die die beiden Kontakte (14, 15) bildende Schichten rechteckig. Zwischen dem ersten Kontakt (14) und dem zweiten Kontakt (15) befindet sich eine Unterbrechung (16), die den ersten Kontakt (14) und den zweiten Kontakt (15) thermisch und elektrisch voneinander trennt. Die Unterbrechung ist in der Aufsicht (vgl. Figur 5) als geradlinig verlaufender rechteckiger Graben zwischen den beiden Kontakten (14, 15) ausgeführt, der sich über die gesamte Länge des Substrats (11) in Richtung des Grabensverlaufs erstreckt. In der Unterbrechung (16) ist eine thermoelektrisch wirksame Schicht (17) angeordnet. Die thermoelektrisch wirksame Schicht (17) wird durch eine Oberseite (18), eine Unterseite (19) sowie die Ober- und Unterseite (18, 19) miteinander verbindende seitliche Begrenzungsflächen (20, 21) begrenzt, wie sich dies aus der vergrößerten Darstellung in Abbildung 8 ergibt.

Die thermoelektrisch wirksame Schicht (17) wird derart in der Unterbrechung (16) angeordnet, dass die Unterseite (19) auf der Substratvorderseite (12) aufliegt und eine der seitlichen Begrenzungsflächen (20) an dem ersten Kontakt (14) sowie eine der seitlichen Begrenzungsflächen (21) an dem zweiten Kontakt (15) anliegen. Über die seitlichen Begrenzungsflächen (20, 21) wird der Wärmestrom (24) in die thermoelektrisch wirksame Schicht (17) ein- bzw. ausgekoppelt. Die Anbindung des thermoelektrischen Elementes (10) an eine Wärmequelle (22) erfolgt mit Hilfe des ersten Kontakts (14) und die Ankopplung des thermoelektrischen Elementes (10) an eine Wärmesenke (23) erfolgt mit Hilfe des zweiten Kontakts (15). Die Anlageflächen an dem ersten und zweiten Kontakt für die seitlichen Begrenzungsflächen (20, 21) verlaufen in der Praxis vorzugsweise geneigt, um die Abscheidung der thermoelektrisch wirksamen Schicht (17) im Wege eines physikalischen Gasphasen-Abscheideprozesses zu verbessern.

Das zweite, in Abbildung 4 dargestellte thermoelektrische Element (10) weist zusätzlich zu dem Ausführungsbeispiel nach Abbildung 3 einen dritten Kontakt (25) und einen vierten Kontakt (26) auf, die jeweils als Kupferschicht auf der Substratrückseite (13) ausgeführt sind. Wie auf der Substratvorderseite (12) befindet sich auch zwischen dem dritten und vierten Kontakt (25, 26) eine Unterbrechung (27), die den dritten und vierten Kontakt (25, 26) thermisch und elektrisch voneinander trennt. Die Unterbrechung (27) verläuft gradlinig und erstreckt sich in Verlaufsrichtung über die gesamte Länge des Substrats (11), wie dies aus der Rückansicht des thermoelektrischen Elementes (10) in Abbildung 6 erkennbar ist. Eine Durchkontaktierung (28) verbindet den ersten Kontakt (14) thermisch und elektrisch mit dem dritten Kontakt (25) und eine Durchkontaktierung (29) verbindet den zweiten Kontakt (15) thermisch und elektrisch mit dem vierten Kontakt (26). Die Durchkontaktierungen (28, 29) sind als Bohrung durch das Substrat (11) ausgeführt, deren Bohrlochwände mit Kupfer metallisiert sind. Die zusätzlichen Kontakte (25, 26) ermöglichen es, die Wärme über die Rückseite ein- bzw. auszukoppeln, wobei der Wärmestrom (24) von der Wärmequelle (22) über den dritten Kontakt (25), die Durchkontaktierung (28), den ersten Kontakt (14), die thermoelektrisch wirksame Schicht (17), den zweiten Kontakt (15), die Durchkontaktierung (29) sowie den vierten Kontakt (26) fließt.

Abbildung 7 zeigt ein drittes Ausführungsbeispiel eines thermoelektrischen Elementes (10) in perspektivischer Darstellung, das im Aufbau im Wesentlichen dem thermoelektrischen Element mit beidseitiger Metallisierung des Substrates nach Abbildung 4 entspricht. Insoweit wird zur Vermeidung von Wiederholungen auf die Ausführungen zum Aufbau des thermoelektrischen Elementes nach Abbildung 4 verwiesen. Ein wesentlicher Unterschied besteht allerdings darin, dass der Verlauf der Unterbrechung (16) zwischen dem ersten Kontakt (14) und dem zweiten Kontakt (15) nicht geradlinig, sondern erfindungsgemäß mäanderförmig ist. Bei übereinstimmenden Abmessungen des Substrats (11) der thermoelektrischen Elemente (1C) nach den Abbildungen 4 und 7 lässt sich durch die mäanderförmige Ausbildung der Unterbrechung (16) deren Länge vergrößern. Bei gleichen Abmessungen des thermoelektrischen Elementes (10) vergrößern sich die seitlichen Begrenzungsflächen (20, 21) der thermoelektrisch wirksamen Schicht (17), die an dem ersten Kontakt (14) und an dem zweiten Kontakt (15) anliegen. Hierdurch wird bei im Wesentlichen übereinstimmendem thermischem Widerstand zwischen dem ersten und zweiten Kontakt (14, 15) des thermoelektrischen Elementes (10) bei übereinstimmender Dicke der thermoelektrisch wirksamen Schicht (17) ein größerer Querschnitt der Anlagefläche geschaffen, so dass der elektrische Widerstand des thermoelektrischen Elementes abnimmt. Durch den nicht geradlinigen Verlauf der Unterbrechung wird daher eine wichtige Anforderung an thermoelektrische Elemente, nämlich eine hohe elektrische Leitfähigkeit bei gleichzeitig niedriger Wärmeleitfähigkeit, erfüllt.

Der nicht geradlinige, insbesondere mäanderförmige Verlauf der Unterbrechung ermöglicht bei übereinstimmender elektrischer Leitfähigkeit wie eine geradlinige Unterbrechung geringere Schichtdicken der thermoelektrisch wirksamen Schicht. Hieraus resultieren Vorteile bei der Herstellung der thermoelektrisch wirksamen Schicht im Wege physikalischer Gasphasen-Depositionsprozesse, da diese mit zunehmender Schichtdicke aufwendiger und teurer werden.

Abbildung 8 zeigt schließlich einen bevorzugten Aufbau der thermoelektrisch wirksamen Schicht (17). Die thermoelektrisch wirksame Schicht umfasst abwechselnd Lagen (30) aus einem Haftmaterial, insbesondere Titan, und Lagen (31) aus einem thermoelektrischem Material, insbesondere Bismuth- Tellurid. Durch diesen mehrlagigen. Aufbau ergibt sich eine mechanisch stabilere Schicht mit einem geringeren thermischen Ausdehnungskoeffizient als reines thermoe-ektrisches Material. Hierdurch wird ein Ablösen der thermoelektrisch wirksamen Schicht (17) an den seitlichen Begrenzungsflächen (20, 21) von dem ersten und zweiten Kontakt (14, 15) verhindert.

Zur Herstellung der thermoelektrischen Elemente nach den Abbildungen 3 - 8 wird zunächst das Substrat (11) aus Glasfaser verstärktem Polyimid mit Kupfer ein- oder beidseitig kaschiert.

In einem anschließenden Schritt wird die Unterbrechung (16) und ggf. die weitere Unterbrechung (27) durch Ätzen strukturiert. In die grabenförmige Unterbrechung (16) wird anschließend die thermoelektrisch wirksame Schicht (17) im Wege eines Sputter-Prozesses eingebracht. Ist die thermoelektrisch wirksame Schicht (17) mehrlagig, wird zunächst die Lage aus Haftmaterial (30) auf der Substratvorderseite (12) abgeschieden und sodann abwechselnd Lagen aus thermoelektrischem Material (31) und Lagen aus Haftmaterial (30). Sofern das thermoelektrische Element (10) entsprechend den Abbildungen 4 - 7 beidseitig Kontakte aufweist, müssen zusätzlich die Durchkontaktierungen (28, 29) durch Bohren des Substrats (11) und anschließendes Metallisieren der Bohrungen hergestellt werden.

Die erfindungsgemäßen thermoelektrischen Elemente (10) zeichnen sich sämtlich dadurch aus, dass der Wärmestrom (24) in einer gemeinsamen, durch die Kontakte auf der Vorderseite und die thermoelektrisch wirksame Schicht aufgespannten Ebene fließt. Hierdurch baut das thermoelektrische Element (10) kompakt und benötigt bei hohem thermischem Widerstand nur wenig thermoelektrisch wirksames Material. Hinzu kommt, dass sich der elektrische Widerstand des thermoelektrischen Elementes durch Anpassung des Verlaufs der Unterbrechung absenken lässt.

**Bezugszeichenliste**

| Nr. | Bezeichnung | Nr. | Bezeichnung |
|---|---|---|---|
| 1 | thermoelektrisches Element | 29 | Durchkontaktierung |
| 2 a, b | Quader | 30 | Lage Haftmaterial |
| 3 a, b | Metallbrücken | 31 | Lage thermoelektrisches Material |
| 4 | heiße Seite | 32 | |
| 5 | kalte Seite | 33 | |
| 6 a, b | Keramikplatten | 34 | |
| 7 | Kastenlänge | 35 | |
| 8 | -- | 36 | |
| 9 | -- | 37 | |
| 10 | thermoelektrisches Element | 38 | |
| 11 | Substrat | 39 | |
| 12 | Substratvorderseite | 40 | |
| 13 | Substratrückseite | 41 | |
| 14 | erster Kontakt | 42 | |
| 15 | zweiter Kontakt | 43 | |
| 16 | Unterbrechung | 44 | |
| 17 | thermoelektrisch wirksame Schicht | 45 | |

(fortgesetzt)

| Nr. | Bezeichnung | Nr. | Bezeichnung |
|-----|-------------|-----|-------------|
| 18 | Oberseite | 46 | |
| 19 | Unterseite | 47 | |
| 20 | seitliche Begrenzungsfläche | 48 | |
| 21 | seitliche Begrenzungsfläche | 49 | |
| 22 | Wärmequelle | 50 | |
| 23 | Wärmesenke | 51 | |
| 24 | Wärmestrom | 52 | |
| 25 | dritter Kontakt | 53 | |
| 26 | vierter Kontakt | 54 | |
| 27 | Unterbrechung | 55 | |
| 28 | Durchkontaktierung | 56 | |

**Patentansprüche**

1. Thermoelektrisches Element (10) umfassend

   - ein Substrat (11) mit einer Substratvorderseite (12) und einer der Substratvorderseite (12) gegenüberliegenden Substratrückseite (13),
   - einen ersten Kontakt (14), der als Schicht auf der Substratvorderseite (12) aufgebracht ist,
   - einen zweiten Kontakt (15), der als Schicht auf der Substratvorderseite (12) aufgebracht ist,
   - eine Unterbrechung (16) zwischen dem ersten und zweiten Kontakt (14, 15), die den ersten und zweiten Kontakt thermisch und elektrisch voneinander trennt,
   - wobei zumindest der Verlauf der Unterbrechung (16) zwischen dem ersten und zweiten Kontakt (14, 15) nicht geradlinig ist und
   - eine thermoelektrisch wirksame Schicht (17) mit einer Oberseite (18) und einer Unterseite (19), die durch seitliche Begrenzungsflächen (20, 21) miteinander verbunden sind,
   - wobei die thermoelektrisch wirksame Schicht (17) derart in der Unterbrechung (16) angeordnet ist, dass die Unterseite (19) auf der Substratvorderseite (12) aufliegt und eine der seitlichen Begrenzungsflächen (20) an dem ersten Kontakt (14) sowie eine der seitlichen Begrenzungsflächen (21) an dem zweiten Kontakt (15) anliegen.

2. Thermoelektrisches Element nach Anspruch 1, **dadurch gekennzeichnet, dass**

   - ein dritter Kontakt (25) als Schicht auf der Substratrückseite (13) aufgebracht ist,
   - ein vierter Kontakt (26) als Schicht auf der Substratrückseite (13) aufgebracht ist,
   - eine Unterbrechung (27) zwischen dem dritten und vierten Kontakt (25, 26) angeordnet ist, die den dritten und vierten Kontakt thermisch und elektrisch voneinander trennt,
   - mindestens eine erste Durchkontaktierung (28) den ersten und dritten Kontakt (14, 25) thermisch und elektrisch miteinander verbindet und
   - mindestens eine zweite Durchkontaktierung (29) den zweiten und vierten Kontakt (15, 26) thermisch und elektrisch miteinander verbindet.

3. Thermoelektrisches Element nach Anspruch 1 oder 2, **dadurch gekennzeichnet, dass** sämtliche Schichten auf der Substratvorderseite (12) und auf der Substratrückseite (13) als Dünnschichten aufgebracht sind.

4. Thermoelektrisches Element nach einem der Ansprüche 1 bis 3, **dadurch gekennzeichnet, dass** die thermoelektrisch wirksame Schicht (17) mehrere Lagen aus einem Haftmaterial (30) und mehrere Lagen aus einem thermoelektrischen Material (31) aufweist und sich die Lagen aus Haftmaterial und thermoelektrischem Material (30, 31) zwischen der Ober- und Unterseite (18, 19) der thermoelektrisch wirksamen Schicht (17) abwechseln.

**5.** Thermoelektrisches Element nach einem der Ansprüche 1 bis 4, **dadurch gekennzeichnet, dass** die Dicke der thermoelektrisch wirksamen Schicht (17) größer als die Dicke des ersten und zweiten Kontaktes (14, 15) ist und die thermoelektrisch wirksame Schicht (17) teilweise den ersten und zweiten Kontakte (14, 15) überlappt.

**6.** Verfahren zur Herstellung eines thermoelektrischen Elementes umfassend die Schritte

- Aufbringen einer Metallisierungsschicht auf einer Substratvorderseite (12) eines Substrats (11),
- Strukturieren einer Unterbrechung (16) in der Metallisierungsschicht durch gezieltes Entfernen der Metallisierungsschicht von der Substratvorderseite (12), so dass die Unterbrechung (16) die Metallisierung in einen ersten Kontakt (14) und einen zweiten Kontakt (15) unterteilt,
- Abscheiden einer thermoelektrisch wirksamen Schicht (17) in die Unterbrechung (16), so dass die Unterbrechung (16) zumindest teilweise mit thermoelektrisch wirksamem Material aufgefüllt wird;

wobei zumindest der Verlauf der Unterbrechung (16) zwischen dem ersten und zweiten Kontakt (14, 15) nicht geradlinig ist.

**7.** Verfahren nach Anspruch 6 weiter umfassend die Schritte

- Aufbringen einer Metallisierungsschicht auf einer der Substratvorderseite (12) gegenüberliegenden Substratrückseite (13),
- Strukturieren einer Unterbrechung (27) in der Metallisierungsschicht auf der Rückseite durch gezieltes Entfernen der Metallisierungsschicht von der Substratrückseite (13), so dass die Unterbrechung die Metallisierung in einen dritten Kontakt (25) und einen vierten Kontakt (26) unterteilt,
- Herstellen mindestens einer ersten Durchkontaktierung (28), die den ersten und dritten Kontakt (14, 25) thermisch und elektrisch miteinander verbindet und
- Herstellen mindestens einer zweiten Durchkontaktierung (29), die den zweiten und vierten Kontakt (15, 26) thermisch und elektrisch miteinander verbindet.

**8.** Verfahren nach Anspruch 6 oder 7, **dadurch gekennzeichnet, dass** sämtliche Schichten als Dünnschichten mit Verfahren der physikalischen oder chemischen Gasphasenabscheidung aufgebracht werden.

**9.** Verfahren nach einem der Ansprüche 6 bis 8, **dadurch gekennzeichnet, dass** die Strukturierung jeder Metallisierungsschicht durch Ätzen erfolgt.

**10.** Verfahren nach einem der Ansprüche 6 bis 9, **dadurch gekennzeichnet, dass** die thermoelektrisch wirksame Schicht (17) in mehreren Lagen (30, 31) in der Unterbrechung (16) abgeschieden wird, wobei zunächst eine Lage mit Haftmaterial (30) auf der Substratvorderseite (12) abgeschieden wird und sodann abwechselnd Lagen aus thermoelektrischem Material und Haftmaterial (30, 31).

**Claims**

**1.** A thermoelectric element (10) comprising

- a substrate (11) comprising a substrate front side (12) and a substrate rear side (13) located opposite the substrate front side (12),
- a first contact (14) applied as layer on the substrate front side (12),
- a second contact (15) applied as layer on the substrate front side (12),
- a gap (16) between the first and second contact (14, 15), which thermally and electrically separates the first and second contact from one another,
- wherein at least the course of the gap (16) between the first and second contact (14, 15) is not straight and
- a thermoelectrically active layer (17) comprising a top side (18) and a bottom side (19), which are connected to one another by lateral delimiting surfaces (20, 21),
- wherein the thermoelectrically active layer (17) is arranged in the gap (16) in such a way that the bottom side (19) bears on the substrate front side (12), and one of the lateral delimiting surfaces (20) bears on the first contact (14) and one of the lateral delimiting surfaces (21) bears on the second contact (15).

**2.** The thermoelectric element according to claim 1, **characterized in that**

- a third contact (25) is applied as layer on the substrate rear side (13),
- a fourth contact (26) is applied as layer on the substrate rear side (13),
- a gap (27), which thermally and electrically separates the third and fourth contact from one another, is arranged between the third and fourth contact (25, 26),
- at least a first through-connection (28) thermally and electrically connects the first and third contact (14, 25) with one another and
- at least a second through-connection (29) thermally and electrically connects the second and fourth contact (15, 26) with one another.

3.  The thermoelectric element according to claim 1 or 2, **characterized in that** all layers are applied as thin layers on the substrate front side (12) and on the substrate rear side (13).

4.  The thermoelectric element according to one of claims 1 to 3, **characterized in that** the thermoelectrically active layer (17) has a plurality of layers of an adhesive material (30) and a plurality of layers of a thermoelectric material (31), and the layers of adhesive material and thermoelectric material (30, 31) alternate between the top and bottom side (18, 19) of the thermoelectrically active layer (17).

5.  The thermoelectric element according to one of claims 1 to 4, **characterized in that** the thickness of the thermoelectrically active layer (17) is greater than the thickness of the first and second contact (14, 15) and the thermoelectrically active layer (17) partially overlaps the first and second contact (14, 15).

6.  A method for producing a thermoelectric element comprising the steps

    - applying a metallization layer on a substrate front side (12) of a substrate (11),
    - structuring a gap (16) in the metallization layer by systematic removal of the metallization layer from the substrate front side (12), so that the gap (16) divides the metallization into a first contact (14) and a second contact (15),
    - depositing a thermoelectrically active layer (17) into the gap (16), so that the gap (16) is at least partially filled with thermoelectrically active material;

    wherein at least the course of the gap (16) between the first and second contact (14, 15) is not straight.

7.  The method according to claim 6 further comprising the steps

    - applying a metallization layer to a substrate rear side (13) located opposite the substrate front side (12),
    - structuring a gap (27) in the metallization layer on the rear side by systematic removal of the metallization layer from the substrate rear side (13), so that the gap divides the metallization into a third contact (25) and a fourth contact (26),
    - establishing at least a first through-connection (28), which thermally and electrically connects the first and third contact (14, 25) to one another and
    - establishing at least a second through-connection (29), which thermally and electrically connects the second and fourth contact (15, 26) to one another.

8.  The method according to claim 6 or 7, **characterized in that** all layers are applied as thin layers by means of physical or chemical vapor deposition methods.

9.  The method according to one of claims 6 to 8, **characterized in that** the structuring of each metallization layer is carried out by etching.

10. The method according to one of claims 6 to 9, **characterized in that** the thermoelectrically active layer (17) is deposited in the gap (16) in a plurality of layers (30, 31), wherein one layer comprising adhesive material (30) is initially deposited on the substrate front side (12) and then alternately layers of thermoelectric material and adhesive material (30, 31).

**Revendications**

1.  Élément thermoélectrique (10), comprenant

- un substrat (11) avec une face avant (12) de substrat et une face arrière (13) de substrat opposée à la face avant (12) de substrat,
- un premier contact (14) qui est appliqué en tant que couche sur la face avant (12) de substrat,
- un deuxième contact (15) qui est appliqué en tant que couche sur la face avant (12) de substrat,
- une interruption (16) entre le premier et le deuxième contacts (14, 15), qui sépare thermiquement et électriquement l'un de l'autre le premier et le deuxième contacts,
- au moins le tracé de l'interruption (16) entre le premier et le deuxième contacts (14, 15) n'étant pas rectiligne et
- une couche (17) thermo-électriquement active, avec une face supérieure (18) et une face inférieure (19) qui sont reliées l'une à l'autre par des surfaces de délimitation (20, 21) latérales,
- la couche (17) thermo-électriquement active étant placée dans l'interruption (16) de telle sorte que la face inférieure (19) s'appuie sur la face avant (12) de substrat et que l'une des surfaces de délimitation (20) latérales s'appuie sur le premier contact (14) et que l'une (21) des surfaces de délimitation latérales s'appuie sur le deuxième contact (15).

2. Élément thermoélectrique selon la revendication 1, **caractérisé**

- **en ce qu'**un troisième contact (25) est appliqué en tant que couche sur la face arrière (13) de substrat,
- **en ce qu'**un quatrième contact (26) est appliqué en tant que couche sur la face arrière (13) de substrat,
- **en ce qu'**une interruption (27) est placée entre le troisième et le quatrième contacts (25, 26), qui sépare thermiquement et électriquement l'un de l'autre le troisième et le quatrième contacts,
- **en ce qu'**au moins un premier via (28) relie thermiquement et électriquement l'un à l'autre le premier et le troisième contacts (14, 25) et
- **en ce qu'**au moins un deuxième via (29) relie thermiquement et électriquement l'un à l'autre le deuxième et le quatrième contact (15, 26).

3. Élément thermoélectrique selon la revendication 1 ou la revendication 2, **caractérisé en ce que** toutes les couches sur la face avant (12) de substrat et sur la face arrière (13) de substrat sont appliquées en couches minces.

4. Élément thermoélectrique selon l'une quelconque des revendications 1 à 3, **caractérisé en ce que** la couche (17) thermo-électriquement active comporte plusieurs couches en une matière adhésive (30) et plusieurs couches en une matière thermoélectrique (31) et **en ce que** les couches (30, 31) en matière adhésive et en matière thermoélectrique s'alternent entre les faces supérieure et inférieure (18, 19) de la couche (17) thermo-électriquement active.

5. Élément thermoélectrique selon l'une quelconque des revendications 1 à 4, **caractérisé en ce que** l'épaisseur de la couche (17) thermo-électriquement active est supérieure à l'épaisseur du premier et du deuxième contacts (14, 15) et **en ce que** la couche (17) thermo-électriquement active chevauche partiellement le premier et le deuxième contacts (14, 15).

6. Procédé destiné à fabriquer un élément thermoélectrique, comprenant les étapes

- de l'application d'une couche de métallisation sur une face avant (12) de substrat d'un substrat (11),
- de la structuration d'une interruption (16) dans la couche de métallisation par retrait ciblé de la couche de métallisation de la face avant (12) de substrat, de telle sorte que l'interruption (16) divise la métallisation en un premier contact (14) et un deuxième contact (15),
- du dépôt d'une couche (17) thermo-électriquement active dans l'interruption (16), de sorte que l'interruption (16) se remplisse au moins partiellement de matière thermo-électriquement active ;

au moins le tracé de l'interruption (16) entre le premier et le deuxième contacts (14, 15) n'étant pas rectiligne.

7. Procédé selon la revendication 6, comprenant par ailleurs les étapes

- de l'application d'une couche de métallisation sur une face arrière (13) de substrat qui est opposée à la face avant (12) de substrat,
- de la structuration d'une interruption (27) dans la couche de métallisation sur la face arrière, par retrait ciblé de la couche de métallisation de la face arrière (13) de substrat, de sorte que l'interruption divise la métallisation en un troisième contact (25) et en un quatrième contact (26),
- de la création d'au moins un premier via (28) qui relie l'un à l'autre thermiquement et électriquement le premier et le troisième contacts (14, 25),

- de la création d'au moins un deuxième via (29) qui relie l'un à l'autre thermiquement et électriquement le deuxième et le quatrième contacts (15, 26).

8. Procédé selon la revendication 6 ou la revendication 7, **caractérisé en ce qu'**on applique toutes les couches en tant que couches minces avec des procédés du dépôt physique ou chimique en phase vapeur.

9. Procédé selon l'une quelconque des revendications 6 à 8, **caractérisé en ce que** la structuration de chaque couche de métallisation s'effectue par gravure.

10. Procédé selon l'une quelconque des revendications 6 à 9, **caractérisé en ce qu'**on dépose la couche (17) thermo-électriquement active en plusieurs couches (30, 31) dans l'interruption (16), sachant que l'on dépose d'abord une couche de matière adhésive (30) sur la face avant (12) de substrat et ensuite en alternance des couches en matière thermo-électrique et en matière adhésive (30, 31).

# Fig. 1

# Fig. 2

# Fig. 3

# Fig. 4

**Fig. 5**

14    17    15

**Fig. 6**

25    27    26

**Fig. 7**

**Fig. 8**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20060076046 A
- US 20110000517 A1